(19) Europäisches Patentamt
European Patent Office
Office européen des brevets

(11) EP 2 716 600 A1

(12) # EUROPEAN PATENT APPLICATION
published in accordance with Art. 153(4) EPC

(43) Date of publication:
**09.04.2014 Bulletin 2014/15**

(21) Application number: **12792422.3**

(22) Date of filing: **30.05.2012**

(51) Int Cl.:
***C01B 31/02*** *(2006.01)* ***B82Y 30/00*** *(2011.01)*
***B82Y 40/00*** *(2011.01)*

(86) International application number:
**PCT/JP2012/064005**

(87) International publication number:
**WO 2012/165514 (06.12.2012 Gazette 2012/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2011 JP 2011122526**

(71) Applicants:
- **Zeon Corporation**
**Chiyoda-ku**
**Tokyo 100-8246 (JP)**
- **National Institute of Advanced Industrial Science and Technology**
**Tokyo 100-8921 (JP)**

(72) Inventors:
- **HIROTA, Mitsuhito**
**Tokyo 100-8246 (JP)**
- **SHIBUYA, Akiyoshi**
**Tokyo 100-8246 (JP)**
- **UEJIMA, Mitsugu**
**Tokyo 100-8246 (JP)**
- **HATA, Kenji**
**Ibaraki 305-8565 (JP)**
- **YUMURA, Motoo**
**Ibaraki 305-8565 (JP)**

(74) Representative: **Vossius & Partner**
**Siebertstrasse 4**
**81675 München (DE)**

(54) # APPARATUS AND METHOD FOR PRODUCING ORIENTED CARBON NANOTUBE AGGREGATE

(57) An apparatus for producing an aligned carbon nanotube aggregate includes: a growth unit (3) that includes a growth furnace (3a) for synthesizing the aligned carbon nanotube aggregate by causing an environment surrounding a catalyst to be an environment of a raw material gas and by heating at least either the catalyst or the raw material gas; a transfer unit (6) that transfers an aligned CNT aggregate production substrate (10) from an inside to an outside of the growth furnace (3a); and a heating section (13c) for heating, from the outside of the growth furnace (3a), an outlet of the growth furnace (3a) through which outlet the aligned CNT aggregate production substrate (10) exits from the growth furnace (3a).

FIG. 1

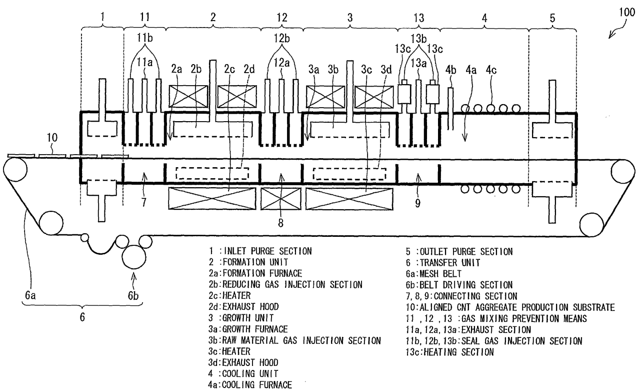

1 :INLET PURGE SECTION
2 :FORMATION UNIT
2a:FORMATION FURNACE
2b:REDUCING GAS INJECTION SECTION
2c:HEATER
2d:EXHAUST HOOD
3 :GROWTH UNIT
3a:GROWTH FURNACE
3b:RAW MATERIAL GAS INJECTION SECTION
3c:HEATER
3d:EXHAUST HOOD
4 :COOLING UNIT
4a:COOLING FURNACE
4b:COOLANT GAS INJECTION SECTION
4c:WATER-COOLED COOLING TUBE
5 :OUTLET PURGE SECTION
6 :TRANSFER UNIT
6a:MESH BELT
6b:BELT DRIVING SECTION
7, 8, 9:CONNECTING SECTION
10:ALIGNED CNT AGGREGATE PRODUCTION SUBSTRATE
11 ,12 ,13 :GAS MIXING PREVENTION MEANS
11a, 12a, 13a:EXHAUST SECTION
11b, 12b, 13b:SEAL GAS INJECTION SECTION
13c:HEATING SECTION



Printed by Jouve, 75001 PARIS (FR)

## Description

### Technical Field

The present invention relates to an apparatus for producing an aligned carbon nanotube aggregate and a method for producing the aligned carbon nanotube aggregate.

### Background Art

Carbon nanotubes (hereinafter referred to also as "CNTs") are carbon structures each structured such that a carbon sheet composed of a planar hexagonal arrangement of carbon atoms is sealed in a cylindrical shape. The CNTs are classified into single-walled CNTs and multiwall CNTs, both of which are expected to develop into functional materials such as electronic device materials, optical element materials, and conducting materials because of their mechanical strength, optical properties, electrical properties, thermal properties, and molecular-adsorbing functions, etc. Among the CNTs, the single-walled CNTs are excellent in various properties such as electrical properties (extremely high in current density), heat properties (comparable in specific thermal conductivity to diamonds), optical properties (emit light in an optical communication band of wavelengths), hydrogen storage capability, and metal catalyst supporting capability. Moreover, the single-walled CNTs exhibit the properties of both semiconductors and metals, and therefore have drawn attention as materials for nanoelectronics devices, nanooptical elements, and energy storage bodies.

Patent Literatures 1 and 2 have been reported as techniques for continuously producing aligned CNT aggregates.

### Citation List

[Patent Literature]

Patent Literature 1
Pamphlet of International Publication No. 2009/128349 (Publication Date: October 22, 2009)
Patent Literature 2
Pamphlet of International Publication No. 2011/001969 (Publication Date: January 6, 2011)

### Summary of Invention

### Technical Problem

However, use of such a conventional technique as described above may cause a problem of an unstable quality of an aligned CNT aggregate. Inventors of the present invention studied a cause for the problem, and made the following finding: a CNT which grows in a vertical direction from a substrate would possibly have a tip (top)-G/D ratio remarkably smaller than a root (bottom)-G/D ratio, so that the CNT has an unstable quality.

It is unclear why the tip-G/D ratio is smaller than the root-G/D ratio. However, this is hypothesized that because a decrease in temperature near an outlet of a growth unit causes a decomposed product of a raw material gas to be amorphous carbon and accumulate mainly at the tip of the CNT.

The present invention has been made in view of the circumstances, and an object of the present invention is to provide (i) an apparatus for producing an aligned CNT aggregate in which a difference between a tip-G/D ratio and a root-G/D ratio is smaller and (ii) a method for producing the aligned carbon nanotube aggregate.

### Solution to Problem

The inventors of the present invention carried out diligent study so as to solve the problem. As a result, the inventors found the following: the problem can be solved by heating a connecting section between a growth unit and a cooling unit, so that an aligned CNT aggregate can be obtained in which a difference between a tip-G/D ratio and a root-G/D ratio is small and which is stable in quality. Based on the finding, the inventors accomplished the present invention.

In order to attain the object, an apparatus of the present invention for producing an aligned carbon nanotube aggregate by synthesizing the aligned carbon nanotube aggregate on a substrate for producing the aligned carbon nanotube aggregate, the substrate being constituted by a base substrate which supports a catalyst on a surface thereof, the apparatus includes: a growth unit that includes a growth furnace for synthesizing the aligned carbon nanotube aggregate by causing an environment surrounding the catalyst to be an environment of a raw material gas and by heating at least either the catalyst or the raw material gas; a transfer unit that transfers the substrate from an inside to an outside of the growth furnace; and heating means for heating, from the outside of the growth furnace, an outlet of the growth furnace through which outlet the substrate exits from the growth furnace.

A method of the present invention for producing an aligned carbon nanotube aggregate by synthesizing the aligned carbon nanotube aggregate on a substrate for producing the aligned carbon nanotube aggregate, the substrate being constituted by a base substrate which supports a catalyst on a surface thereof, the method includes: a growth step of synthesizing the aligned carbon nanotube aggregate by use of a production apparatus, the production apparatus including: a growth unit that includes a growth furnace for synthesizing the aligned carbon nanotube aggregate by causing an environment surrounding the catalyst to be an environment of a raw material gas and by heating at least either the catalyst or the raw material gas; a transfer unit that transfers the substrate from an inside to an outside of the growth furnace; and heating means for heating, from the outside of the growth furnace, an outlet of the growth furnace through which outlet the substrate exits from the growth furnace, and the growth step being carried out in the growth unit while the outlet is heated from the outside of the growth furnace.

Advantageous Effects of Invention

The present invention yields an effect of producing an aligned CNT aggregate in which a difference between a tip-G/D ratio and a root-G/D ratio is smaller.

For a fuller understanding of the nature and advantages of the invention, reference should be made to the ensuing detailed description taken in conjunction with the accompanying drawings.

Brief Description of Drawings

Fig. 1 is a view schematically illustrating a configuration of a production apparatus 100, which is an example of an apparatus of the present invention for producing an aligned CNT aggregate.

Description of Embodiments

The following description specifically discusses an embodiment of the present invention.

(Aligned CNT Aggregate)

First, an aligned CNT aggregate obtained by the present invention is described below.

An aligned CNT aggregate that is produced in the present invention refers to a structure in which a large number of CNTs having grown from a substrate being constituted by a base substrate which supports a catalyst on a surface thereof are aligned along a particular direction. A specific surface area of the aligned CNT aggregate when the CNTs are mostly unopened is preferably not less than 600 $m^2/g$, and more preferably not less than 800 $m^2/g$. An aligned CNT aggregate having a larger specific surface area is preferable because such an aligned CNT aggregate can reduce an amount of impurities such as metals or carbon impurities. A total amount of the impurities is preferably not more than 40% of a CNT weight.

A weight density of the aligned CNT aggregate is preferably not less than 0.002 $g/cm^3$ but not more than 0.2 $g/cm^3$. In a case where the weight density is not more than 0.2 $g/cm^3$, there will be a weakening in binding of CNTs constituting the aligned CNT aggregate. Such a weakening renders the aligned CNT aggregate likely to be homogenously dispersed when stirred into a solvent or the like. That is, a weight density of not more than 0.2 $g/cm^3$ makes it easy to obtain a homogenous dispersion liquid. Alternatively, a weight density of not less than 0.002 $g/cm^3$ leads to an improvement in the integrity of the aligned CNT aggregate. Such an improvement can prevent the aligned CNT aggregate from being unbound, thus making it easy to handle the aligned CNT aggregate.

An aligned CNT aggregate which is aligned along a particular direction preferably has a high degree of orientation. The high degree of orientation can be evaluated by at least any one of the following 1. to 3.

1. In a case where the aligned CNT aggregate is irradiated with X rays from a first direction parallel with the longitudinal direction of the CNTs and from a second direction perpendicular to the first direction, and an x-ray diffraction intensity of the aligned CNT aggregate is then measured (by $\theta$-$2\theta$ method), a $\theta$ angle and a reflection direction where a reflection intensity from the second direction is greater than that from the first direction are obtained. Further, a $\theta$ angle and a reflection direction where the reflection intensity from the first direction is greater than that from the second direction are obtained.
2. In a case where an X-ray diffraction intensity is measured from a two-dimensionally diffraction pattern image obtained by irradiating the aligned CNT aggregate with X rays from the direction perpendicular to the longitudinal direction of the CNTs (by Laue method), a diffraction peak pattern indicating presence of anisotropy appears.

3. A Herman's orientation factor calculated on the basis of the X-ray diffraction intensity obtained by $\theta$-2$\theta$ method or Laue method is more than 0 but less than 1, preferably not less than 0.25 but not more than 1.

According to the X-ray diffraction method, (i) diffraction intensities of a (CP) diffraction peak and a (002) peak based on packing between the single-walled CNTs, and (ii) a diffraction peak intensity in a direction of X-rays that enter parallel and perpendicular to (100) and (110) peaks based on a six-membered carbon ring constituting the single-walled CNTs are different from each other.

In order for an aligned CNT aggregate to exhibit orientation and a large specific surface area, it is preferable that the height (length) of the aligned CNT aggregate be in a range of not less than 10 μm to not more than 10 cm. A height of not less than 10 μm leads to an improvement in orientation. Alternatively, a height of not more than 10 cm makes it possible to improve the specific surface area, because such a height makes rapid generation possible and the adhesion of carbonaceous impurities can therefore be controlled.

The aligned CNT aggregate preferably has a G/D ratio of not less than 3, and more preferably of not less than 4. The term "G/D ratio" means an index that is commonly used to evaluate the quality of CNTs. A raman spectrum of CNTs as measured by a raman spectroscopic instrument is observed in vibration modes called "G band" (near 1,600 $cm^{-1}$) and "D band" (near 1,350 $cm^{-1}$). The G band is a vibration mode derived from hexagonal lattice structures of graphite appearing as cylindrical surfaces of CNTs, and the D band is a vibration mode derived from amorphous parts. Therefore, with a higher peak intensity ratio of the G band to the D band (G/D ratio), the CNTs can be evaluated to be higher in crystallinity.

<Example of Production Apparatus>

Next, an example of a production apparatus of the present invention for producing an aligned CNT aggregate is described with reference to Fig. 1. Fig. 1 is a view schematically illustrating a configuration of the production apparatus 100, which is an example of the production apparatus of the present invention for producing an aligned CNT aggregate.

As illustrated in Fig. 1, the production apparatus 100 includes an inlet purge section 1, a formation unit 2, a growth unit 3, a transfer unit 6, gas mixing prevention means 11, 12, and 13, connecting sections 7, 8, and 9, a cooling unit 4, and an outlet purge section 5.

Moreover, the production apparatus 100 continuously produces aligned CNT aggregates on a plurality of aligned CNT aggregate production substrates 10.

An aligned CNT aggregate production substrate (substrate for producing an aligned carbon nanotube aggregate) 10 is a substrate being constituted by a base substrate which supports thereon a catalyst for a CNT growth reaction.

(Base substrate)

It is only necessary that the base substrate be a member capable of supporting a catalyst for a CNT growth on a surface thereof. The base substrate can preferably maintain its shape even at a high temperature of not lower than 400°C. Examples of materials usable for producing CNTs include: metals such as iron, nickel, chromium, molybdenum, tungsten, titanium, aluminum, manganese, cobalt, copper, silver, gold, platinum, niobium, tantalum, lead, zinc, gallium, indium, germanium, and antimony; alloys and oxides containing these metals; nonmetals such as silicon, quartz, glass, mica, graphite, and diamond; and ceramic. The metal materials, which are lower in cost than silicon and ceramic, are preferable. In particular, a Fe-Cr (iron-chromium) alloy, a Fe-Ni (iron-nickel) alloy, a Fe-Cr-Ni (iron-chromium-nickel) alloy, and the like are suitable.

The base substrate may take the form of a flat plate, a thin film, a block, or the like. However, in particular, the form of the flat plate in which form the base substrate has a large surface area for its volume is advantageous to mass production.

(Carburizing Prevention Layer)

The base substrate may have a carburizing prevention layer formed on at least either a front or back surface thereof. It is desirable that the base substrate have a carburizing prevention layer formed on each of the front and back surfaces thereof. The carburizing prevention layer is a protecting layer for preventing the base substrate from being carburized and therefore deformed in the step of generating carbon nanotubes.

It is preferable that the carburizing prevention layer be composed of a metal or ceramic material, or especially preferably the ceramic material, which is highly effective in preventing carburizing. Examples of the metal include copper and aluminum. Examples of the ceramic material include: oxides such as aluminum oxide, silicon oxide, zirconium oxide, magnesium oxide, titanium oxide, silica alumina, chromium oxide, boron oxide, calcium oxide, and zinc oxide; and nitrides such as aluminum nitride and silicon nitride. Among them, aluminum oxide and silicon oxide are preferable because they are highly effective in preventing carburizing.

(Catalyst)

According to the aligned CNT aggregate production substrate 10, the base substrate (or a carburizing prevention layer in a case where the carburizing prevention layer is provided on the base substrate) has a catalyst supported thereon. Any type of catalyst that is usable for production of CNTs can be used. Examples of the catalyst include iron, nickel, cobalt, molybdenum, a chloride thereof, an alloy thereof, and a complex or layer thereof with aluminum, alumina, titania, titanium nitride, or silicon oxide. Examples that can be given are an iron-molybdenum thin film, an alumina-iron thin film, an alumina-cobalt thin film, an alumina-iron-molybdenum thin film, an aluminum-iron thin film, and an aluminum-iron-molybdenum thin film. The catalyst can be used in a range of existential quantities that is usable for production of CNTs. For example, in the case of use of iron, it is preferable that the thickness of a film formed be in a range of not less than 0.1 nm to not more than 100 nm, more preferably not less than 0.5 nm to not more than 5 nm, or especially preferably not less than 0.8 nm to not more than 2 nm.

It is possible to apply either a wet or dry process to the formation of the catalyst onto the surface of the base substrate. For example, it is possible to apply a sputtering evaporation method or a method for spreading/calcining a liquid obtained by dispersing fine metal particles in an appropriate solvent. Further, it is possible to form the catalyst into any shape with concomitant use of patterning obtained by applying well-known photolithography, nanoprinting, or the like.

[Inlet Purge Section 1]

The inlet purge section 1 is a set of devices for preventing the outside air from flowing into a furnace of the production apparatus 100 through an inlet of the aligned CNT aggregate production substrate 10. The inlet purge section 1 has such a function that an environment surrounding the aligned CNT aggregate production substrate 10 transferred into the production apparatus 100 is replaced by a purge gas. Specifically, the inlet purge section 1 mainly includes a furnace or chamber in which the purge gas is retained, and an injection section for injecting the purge gas. It is preferable that the purge gas be an inert gas. In particular, in terms of safety, cost, etc., it is preferable that the purge gas be nitrogen. In a case where the inlet of the aligned CNT aggregate production substrate 10 is always open, e.g., in a case where the aligned CNT aggregate production substrate 10 is transferred by use of a belt-conveyor, it is preferable to use, as a purge gas injection section, a gas curtain device that injects the purge gas from up and down in the form of a shower, in order to prevent the outside air from flowing in through an inlet of the apparatus. The gas mixing prevention means 11 (described later) can solely prevent the outside air from flowing into the furnace. However, the production apparatus 100 preferably includes the inlet purge section 1 so as to increase its safety.

[Formation Unit 2]

The formation unit 2 is a set of devices for realizing a formation step, and has a function of causing an environment surrounding a catalyst formed on a surface of the aligned CNT aggregate production substrate 10 to be an environment of a reducing gas and heating at least either the catalyst or the reducing gas.

The formation step (specifically described later) is a step of causing an environment surrounding the catalyst supported on the aligned CNT aggregate production substrate 10 to be an environment of the reducing gas and heating at least either the catalyst or the reducing gas.

Specific examples of the formation unit 2 include a formation furnace 2a in which the reducing gas is retained, a reducing gas injection section 2b for injecting the reducing gas, an exhaust hood 2d from which a gas in the formation furnace 2a is exhausted, and a heater 2c for heating at least either the catalyst or the reducing gas. The heater 2c is preferably capable of carrying out heating in a range of 400°C to 1,100°C. Examples of the heater 2c include a resistance heating heater, an infrared heating heater, and an electromagnetic induction heater.

(Reducing Gas)

In general, a reducing gas is a gas that has at least one of the effects of reducing a catalyst, stimulating the catalyst to become fine particles suitable for the growth of CNTs, and improving the activity of the catalyst, and that is in a gaseous state at a growth temperature of CNTs. A typically applicable example of the reducing gas is a gas having reducing ability, such as hydrogen gas, ammonium, water vapor, or a mixture thereof. Alternatively, it is possible to apply a mixed gas obtained by mixing hydrogen gas with an inert gas such as helium gas, argon gas, or nitrogen gas. The reducing gas may be used in a formation step or in a growth step as appropriate.

(Formation Step)

The formation step is a step of causing an environment surrounding the catalyst supported on the aligned CNT aggregate production substrate 10 to be an environment of the reducing gas and heating at least either the catalyst or the reducing gas. This step brings about at least one of the effects of reducing the catalyst, stimulating the catalyst to become fine particles suitable for the growth of CNTs, and improving the activity of the catalyst. For example, when the catalyst is an alumina-iron thin film, the iron catalyst is reduced to become fine particles, whereby a large number of fine iron particles in nanometer size are formed on the alumina layer. Thus, the catalyst is prepared to be a catalyst suitable to production of aligned CNT aggregates. It is possible to produce CNTs without carrying out the formation step. However, in a case where the formation step is carried out, it is possible to dramatically increase a production volume and quality of the aligned CNT aggregate.

In a case where a unit which carries out the formation step and a unit which carries out the growth step are separately provided as in the present embodiment, carbon contaminants are prevented from adhering to an inner wall of the formation furnace 2a. This is more preferable for production of the aligned CNT aggregate.

[Growth Unit 3]

The growth unit 3 is a set of devices for realizing a growth step. The growth step (specifically described later) is a step of synthesizing an aligned CNT aggregate by (i) transferring the aligned CNT aggregate production substrate 10 into a growth furnace, (ii) causing the environment surrounding the catalyst to be an environment of the raw material gas in the growth furnace, and (iii) heating at least either the catalyst or the raw material gas.

The growth unit 3 includes a growth furnace 3a which retains the environment surrounding the aligned CNT aggregate production substrate 10 as an environment of the raw material gas, a raw material gas injection section 3b for injecting a raw material gas onto the aligned CNT aggregate production substrate 10, an exhaust hood 3d from which a gas in the growth furnace 3a is exhausted, and a heater 3c for heating at least either the catalyst or the raw material gas.

The raw material gas injection section 3b injects the raw material gas onto the aligned CNT aggregate production substrate 10.

The growth unit 3 includes at least one raw material gas injection section 3b and at least one exhaust hood 3d. It is preferable that a total flow of gas injected from all the raw material gas injection sections 3b and a total flow of gas exhausted from all the exhaust hoods 3d be equal or substantially equal in amount. This prevents the raw material gas from flowing out of the growth furnace 3a and prevents gas outside the growth furnace 3a from flowing into the growth furnace 3a.

The heater 3c is preferably capable of carrying out heating in a range of 400°C to 1,100°C. Examples of the heater 3c include a resistance heating heater, an infrared heating heater, and an electromagnetic induction heater.

(Raw Material Gas)

As a raw material gas, any substance that can be a raw material for CNTs can be used. For example, gases having raw-material carbon sources at the growth temperature can be used. Among them, hydrocarbons such as methane, ethane, ethylene, propane, butane, pentane, hexane, heptane, propylene, and acetylene are suitable. In addition, lower alcohols such as methanol and ethanol, and mixtures thereof can be used. Further, the raw material gas may be diluted with an inert gas.

(Inert Gas)

The inert gas only needs to be a gas that is inert at the temperature at which CNTs grow, does not cause a decrease in activity of the catalyst, and does not react with the growing CNTs. Examples that can be given are helium, argon, nitrogen, neon, krypton, and mixtures thereof. In particular, nitrogen, helium, argon, and mixtures thereof are suitable.

(Catalyst Activation Material)

It is more preferable that the growth step be carried out in the presence of a catalyst activation material in an atmosphere in which the CNT growth reaction is carried out. The addition of the catalyst activation material makes it possible to further improve the efficiency in the production of carbon nanotubes and the purity of the carbon nanotubes.

The catalyst activation material is more preferably an oxygen-containing substance, and is still more preferably a substance that does no significant damage to CNTs at the CNT growth temperature. Effective examples include: water; low-carbon oxygen-containing compounds such as oxygen, ozone, acidic gases, nitrogen oxide, carbon monoxide, and carbon dioxide; alcohols such as ethanol and methanol; ethers such as tetrahydrofuran; ketones such as acetone; aldehydes; esters; and mixtures of thereof. Among them, water, oxygen, carbon dioxide, carbon monoxide, and ethers are preferable. In particular, water and carbon dioxide are suitable.

The catalyst activation material is not particularly limited in amount to be added. However, when the catalyst activation material is water vapor, the catalyst activation material only needs to be added in a range preferably of not less than 10 ppm to not more than 10,000 ppm, more preferably of not less than 50 ppm to not more than 1,000 ppm, and still more preferably of not less than 200 ppm to not more than 700 ppm, in a concentration in an environment surrounding the catalyst.

The mechanism by which the catalyst activation material functions is currently supposed to be as follows: In the process of growth of CNTs, adhesion of by-products such as amorphous carbon and graphite to the catalyst causes deactivation of the catalyst and the growth of CNTs is therefore inhibited. However, the presence of the catalyst activation material causes amorphous carbon and graphite to be oxidized into carbon monoxide, carbon dioxide, or the like and therefore gasified. Therefore, the catalyst activation material is believed to cleanse a catalyst layer and express the function (catalyst activation function) of enhancing the activity of the catalyst and extending the active longevity of the catalyst.

Note that compounds containing carbon and oxygen such as alcohols and carbon monoxide can act as both a raw material gas and a catalyst activation material. For example, it is expected the compounds containing carbon and oxygen act as catalyst activation materials when used in combination with a raw material gas that is easily decomposed to be a carbon source (e.g., ethylene). Meanwhile, it is expected the compounds containing carbon and oxygen act as raw material gases when used in combination with a catalyst activation material having a high activity (e.g., water). Furthermore, it is expected, in the case of, for example, carbon monoxide, that carbon atoms which are generated by being decomposed serve as carbon sources of the CNT growth reaction, whereas oxygen atoms act as catalyst activation materials which gasify, by oxidization, amorphous carbon, graphite, and the like.

(Environment of High-carbon Concentration)

An environment of high-carbon concentration means a growth atmosphere in which the proportion of the raw material gas to the total flow is approximately 2 to 20%. Since the activity of the catalyst is remarkably improved particularly in the presence of the catalyst activation material, the catalyst is not deactivated even in an environment of high-carbon concentration. Thus, long-term growth of CNTs is made possible, and the growth rate is remarkably improved. However, in an environment of high-carbon concentration, a large amount of carbon contaminants easily adhere to a furnace wall and the like, as compared with an environment of low-carbon concentration. Moreover, the large amount of carbon contaminants may cause a decrease in G/D ratio at a tip of an aligned CNT aggregate. An apparatus of the present invention for producing an aligned CNT aggregate can prevent carbon contaminants such as amorphous carbon from adhering to a tip of the aligned CNT aggregate. This makes it possible to produce an aligned CNT aggregate in which a difference between a tip-G/D ratio and a root-G/D ratio is smaller.

(Growth Step)

As described above, the growth step is a step of synthesizing an aligned carbon nanotube aggregate by (i) transferring the aligned CNT aggregate production substrate 10 into the growth furnace, (ii) causing the environment surrounding the catalyst to be an environment of the raw material gas in the growth furnace, and (iii) heating at least either the catalyst or the raw material gas. That is, in the growth step, the aligned carbon nanotube aggregate is synthesized on the base substrate by a chemical vapor deposition (CVD) method. It is only necessary that in the growth step of the production method of the present invention, such an aligned CNT aggregate be synthesized while an outlet of the growth furnace 3a through which outlet the aligned CNT aggregate production substrate 10 exits from the growth furnace 3a is heated from an outside of the growth furnace 3a.

Moreover, for example, it is only necessary that in the growth step, the aligned CNT aggregate be synthesized on the base substrate by the CVD method after or while the raw material gas for a CNT is supplied to the growth furnace into which a plurality of base substrates are continuously transferred.

It is preferable that the aligned CNT aggregate be synthesized on the aligned CNT aggregate production substrate 10 in the growth furnace 3a at a pressure of not lower than $10^2$ Pa but not higher than $10^7$ Pa (an atmospheric pressure of 100), and more preferably of not lower than $10^4$ Pa but not higher than $3 \times 10^5$ Pa (an atmospheric pressure of 3).

According to the growth furnace 3a, the reaction temperature at which CNTs are synthesized is appropriately determined in consideration of the metal catalyst, the raw-material carbon source, the reaction pressure and the like. In a case where the growth step further includes the step of adding the catalyst activation material in order to eliminate a by-product that serves as a factor of catalyst deactivation, it is desirable that the reaction temperature be set in such a temperature range that the catalyst activation material sufficiently expresses its effect. That is, the most desirable temperature range has a lower-limit temperature at or above which the catalyst activation material can remove by-products such as amorphous carbon and graphite and a higher-limit temperature at or below which the CNTs, which are main products, are not oxidized by the catalyst activation material.

Specifically, the reaction temperature is preferably not less than 400°C but not more than 1,100°C, and is more preferably not less than 600°C but not more than 900°C. Particularly in a case where the catalyst activation material is added, the reaction temperature falling within the above range allows an effect of the catalyst activation material to be sufficiently expressed and makes it possible to prevent the catalyst activation material from reacting with CNT.

[Transfer Unit 6]

The transfer unit 6 is a set of devices necessary for transferring the aligned CNT aggregate production substrate 10 at least from the formation unit 2 to the growth unit 3. Specific examples of the transfer unit 6 include a belt conveyer transfer unit mainly including a mesh belt 6a and a belt driving section 6b using a reducer-equipped electric motor.

According to the present embodiment, the transfer unit 6 successively transfers a plurality of aligned CNT aggregate production substrates 10 to each of the units of the production apparatus 100 (see Fig. 1). However, it is only necessary that the transfer unit included in the production apparatus for the aligned carbon nanotube aggregate of the present invention transfer the base substrate from an inside to an outside of the growth furnace.

[Connecting Sections 7, 8, and 9]

The connecting sections 7, 8, and 9 are a set of devices via which the respective furnace spaces of the units are spatially connected and which serve to prevent an aligned CNT aggregate production substrate 10 from being exposed to the outside air while the aligned CNT aggregate production substrate 10 is transferred from one unit to another unit. Specific examples of the connecting sections 7, 8, and 9 include a furnace or chamber capable of shielding an environment surrounding the aligned CNT aggregate production substrate 10 from the outside air and passing the aligned CNT aggregate production substrate 10 from one unit to another unit.

[Gas mixing prevention means 11, 12, and 13]

The gas mixing prevention means 11, 12, and 13 are a set of devices for preventing the outside air from mixing with gases in the respective furnace spaces of the production apparatus 100 or preventing gases in the respective furnaces (e.g., the formation furnace 2a, the growth furnace 3a, the cooling furnace 4a) of the production apparatus 100 from mixing with each other. The gas mixing prevention means 11, 12, and 13 are provided near inlets and outlets for transferring the aligned CNT aggregate production substrate 10, or in the connecting sections 7, 8, and 9 which connect spaces in the production apparatus 100. The gas mixing prevention means 11, 12, and 13 include (i) respective at least one seal gas injecting sections (seal gas injection means) 11b, 12b, and 13b each of which injects a seal gas along aperture planes of the inlets and the outlets of the aligned CNT aggregate production substrate 10 in the respective furnaces and (ii) respective at least one exhaust sections (exhaust means) 11a, 12a, and 13a each of which exhausts the seal gas thus injected (and other neighboring gases) to an outside of the production apparatus 100 mainly by sucking the seal gas so as to prevent the seal gas from entering the respective furnaces. In a case where the seal gas injecting sections (seal gas injection means) 11b, 12b, and 13b inject the seal gas along the aperture planes of the furnaces, the seal gas blocks the inlets and outlets of the furnaces. This prevents the gas outside the furnaces from flowing into the furnaces. Moreover, in a case where the production apparatus 100 causes each of the exhaust sections (exhaust means) 11a, 12a, and 13a to (i) suck the seal gas so as to prevent the seal gas from entering a furnace such as the growth furnace 3a through an outlet of the furnace and (ii) exhaust the sucked gas to the outside thereof, the production apparatus 100 prevents the seal gas from flowing into the furnace. It is preferable that the seal gas be an inert gas. In particular, in terms of safety, cost, etc., it is preferable that the seal gas be nitrogen. The seal gas injection sections 11b, 12b, and 13b and the exhaust sections 11a, 12a, and 13a may be provided so that one of the exhaust sections 11a, 12a, and 13a is located adjacent to a corresponding one of the seal gas injection sections 11b, 12b, and 13b or so that the exhaust sections 11a, 12a, and 13a face, across the mesh belt, the seal gas injection sections 11b, 12b, and 13b, respectively. However, it is preferable that the seal gas injection sections 11b, 12b, and 13b and the exhaust sections 11a, 12a, and 13a be provided so that an overall configuration of the gas mixing prevention means is symmetrically located along a furnace length direction. For example, it is preferable that two seal gas injection sections be provided at respective both sides of one exhaust section so that the overall configuration of the gas mixing prevention means has a structure symmetrically located along the furnace length direction about a center of the one exhaust section (see Fig. 1). Further, it is preferable that a total flow of gas injected from the seal gas injection sections 11b, 12b and 13b and a total flow of gas exhausted from the exhaust sections be substantially equal in amount. This makes it possible to (i) prevent gases which flow from spaces on both sides of the respective gas mixing prevention means 11, 12, and 13 from mixing with each other and (ii) prevent the seal gas from flowing into the spaces. In a case where the gas mixing prevention means 12 and 13 are provided on both sides of the growth furnace 3a, it is possible to prevent a flow of the seal gas and a flow of a gas in the growth furnace 3a from interfering with each other. Furthermore, turbulence in the flow of the gas due to the flow of the seal gas into the growth furnace 3a is also prevented. Accordingly, it is possible to provide the production apparatus 100 which is suitable for successively producing the aligned CNT aggregates.

It is preferable that the gas mixing prevention means 11, 12, and 13 prevent inflow of the gas so that the production of the aligned CNT aggregates is not inhibited. Particularly in a case where the formation step is carried out, it is preferable that the gas mixing prevention means 11 and 12 prevent the raw material gas from flowing into the formation furnace 2a so that the concentration of carbon atoms in the environment of the reducing gas in the formation furnace 2a is kept smaller than or equal to $5 \times 10^{22}$ atoms/m$^3$, and more preferably smaller than or equal to $1 \times 10^{22}$ atoms/m$^3$.

(Concentration of Carbon Atoms)

Inflow of the raw material gas into the formation furnace 2a exerts a harmful influence on the growth of CNTs. It is preferable that the inflow of the raw material gas into the formation furnace 2a be prevented by the gas mixing prevention means 11 and 12 so that the concentration of carbon atoms in the environment of the reducing gas in the formation furnace 2a is kept smaller than or equal to $5 \times 10^{22}$ atoms/m$^3$, and more preferably smaller than or equal to $1 \times 10^{22}$ atoms/m$^3$. The "concentration of carbon atoms" here is calculated according to Eq. (1):
[Eq. (1)]

$$(\text{Concentration of Carbon Atoms}) = \sum_{l} C_l \frac{\rho_l D_l}{M_l} N_A \cdots (1)$$

where with respect to the types of gas contained in the reducing gas (i = 1, 2, ...), the concentration (ppmv) is denoted by $D_1$, $D_2$, ..., the density in a standard condition (g/m$^3$) is denoted by $\rho_1$, $\rho_2$, ..., the molecular weight is denoted by $M_1$, $M_2$, ..., and the number of carbon atoms contained in each gas molecule is denoted by $C_1$, $C_2$, ..., and the Avogadro's number is denoted by $N_A$.

The production volume and quality of CNTs can be satisfactorily maintained by keeping the concentration of carbon atoms in the environment of the reducing gas in the formation furnace 2a at not more than $5 \times 10^{22}$ atoms/m$^3$. That is, the concentration of carbon atoms of $5 \times 10^{22}$ atoms/m$^3$ or greater may inhibit, in the formation step, at least one of the effects of reducing the catalyst, stimulating the catalyst to become fine particles suitable for the growth of CNTs, and improving the activity of the catalyst, whereby the production volume and quality of CNTs during the growth step may be reduced.

[Heating section 13c]

A heating section (heating means) 13c heats the seal gas injected from the seal gas injection section 13b. That is, according to the production method of the present invention, the growth step is carried out while the heating section 13c is heating the seal gas.

In a case where the seal gas thus heated heats (i) the outlet of the growth furnace 3a through which outlet the aligned CNT aggregate production substrate 10 exits from the growth furnace 3a and (ii) an area located near the outlet, temperatures increase at the outlet and the area located near the outlet. This makes it possible to obtain an aligned CNT aggregate in which a difference between the tip-G/D ratio and the root-G/D ratio is small and which is stable in quality.

Examples of a specific configuration of the heating section 13c include (i) a configuration in which the seal gas is heated via a tube around which a heater is provided, the tube transferring the seal gas, (ii) a configuration in which the seal gas is heated by providing, near an opening through which the seal gas is injected, a buffer tank heated by a heater or the like, and (iii) a configuration in which the entire connecting section 9 is heated by a heater.

It is only necessary that a temperature at which the heating section 13c carries out the heating be set as appropriate in accordance with an intended quality of the aligned CNT aggregate, a temperature for the CNT growth reaction, etc. For example, it is more preferable that the seal gas be heated at not less than 300°C but not more than 800°C. The temperature falling within the above range can make smaller a difference between the tip-G/D ratio and the root-G/D ratio without reducing the root-G/D ratio. This makes it possible to stably produce a high-quality aligned CNT aggregate.

The description of the present embodiment takes, as an example of a specific configuration of the heating means of the present invention, the heating section which heats the seal gas. However, it is only necessary that the specific configuration of the heating means be a configuration in which the heating means heats, from the outside of the growth furnace, the outlet of the growth furnace through which outlet the base substrate exits from the growth furnace. Moreover, in a case where, as in the present embodiment, the base substrate is transferred from the growth unit to another unit such as the cooling unit via the connecting section, it is only necessary that the heating means heat an internal space of the connecting section.

[Cooling Unit 4]

The cooling unit 4 is a set of devices necessary for cooling down the aligned CNT aggregate production substrate 10 on which an aligned CNT aggregate has grown. The cooling unit has a function of exerting antioxidant and cooling effects on the aligned CNT aggregate, the catalyst, and the base substrate after the growth step. Specific examples of the cooling unit 4 include: a cooling furnace 4a in which a coolant gas is retained; a water-cooled cooling tube 4c disposed to surround an internal space of the cooling furnace, in the case of a water-cooled type; and a coolant gas injection section 4b that injects a coolant gas into the cooling furnace, in the case of an air-cooled type. Further, the water-cooled type and the air-cooled type may be combined.

(Cooling Step)

A cooling step is a step of, after the growth step, cooling down the aligned CNT aggregate, the catalyst, and the base substrate. After the growth step, the aligned CNT aggregate, the catalyst, and the base substrate are high in temperature, and therefore may be oxidized when placed in the presence of oxygen. This is prevented by, for example, cooling down the aligned CNT aggregate, the catalyst, and the base substrate to 400°C or lower, and more preferably 200°C or lower in the presence of a coolant gas. Specifically, a coolant gas or the like can be used for the cooling. It is preferable that the coolant gas be an inert gas. In particular, in terms of safety, cost, etc., it is preferable that the coolant gas be nitrogen.

[Outlet Purge Section 5]

The outlet purge section 5 is a set of devices for preventing the outside air from flowing into a furnace of the apparatus through an outlet of the aligned CNT aggregate production substrate 10. The outlet purge section 5 has a function of causing the environment surrounding the aligned CNT aggregate production substrate 10 to be an environment of a purge gas. Specific examples of the outlet purge section 5 include a furnace or chamber in which the environment of the purge gas is retained and an injection section for injecting the purge gas. It is preferable that the purge gas be an inert gas. In particular, in terms of safety, cost, etc., it is preferable that the purge gas be nitrogen. In a case where the outlet of the aligned CNT aggregate production substrate 10 is always open as in the case of a belt-conveyor type, it is preferable to use, as a purge gas injection section, a gas curtain device that injects the purge gas from up and down in the form of a shower, in order to prevent the outside air from flowing in through an outlet of the apparatus. The gas mixing prevention means 13 can solely prevent the outside air from flowing into the furnace. However, it is preferable that the production apparatus 100 include the outlet purge section 5 so as to increase safety of the production apparatus 100.

[Materials for Those Components of the Apparatus Which Are Exposed to Either the Reducing Gas or the Raw Material Gas]

Components of the production apparatus 100 such as the formation furnace 2a, the reducing gas injection section 2b, the exhaust hood 2d of the formation unit 2, the growth furnace 3a, the raw material gas injection section 3b, the exhaust hood 3d of the growth unit 3, the mesh belt 6a, the seal gas injection sections 11b, 12b, and 13b and the exhaust sections 11a, 12a, and 13a of the respective gas mixing prevention means 11, 12, and 13, the furnaces of the respective connecting sections 7, 8, and 9, and the exhaust flow stabilization section 20 are each exposed to either the reducing gas or the raw material gas. As materials for those components of the apparatus, heat-resistance alloys are preferable in terms of resistance to high temperature, precision of processing, degree of freedom of processing, and cost. Examples of the heat-resistance alloys include heat-resistant steel, stainless steel, and nickel-based alloys. In general, heat-resistant steel refers to steel that contains Fe in major proportions and other alloys in concentrations of not more than 50%. Moreover, stainless steel refers to steel that contains Fe in major proportions, other alloys in concentrations of not more than 50%, and approximately not less than 12% of Cr. Further, examples of the nickel-based alloys include alloys obtained by adding Mo, Cr, Fe, and the like to Ni. For example, SUS 310, Inconel 600, Inconel 601, Inconel 625, Incoloy 800, MC Alloy, Haynes 230 Alloy are preferable in terms of heat resistance, mechanical strength, chemical stability, and low cost.

In a case where a heat-resistant alloy is used, carbon contaminants that adhere to the wall surfaces and the like when CNTs are synthesized in a high-carbon environment can be reduced by a process for either plating a surface of the heat-resistant alloy with molten aluminum or polishing the surface so that the surface has an arithmetic average roughness Ra $\leq$ 2 $\mu$m. Such a process is more preferable for producing the aligned CNT aggregates.

The present invention is not limited to the description of the preferred embodiments above, but may be applied in many variations within the scope of gist thereof.

For example, through a change in production conditions such as a raw material gas and a heating temperature, it is possible to change CNTs to be produced by the production device from/to single-walled CNTs to/from multiwall CNTs, and it is also possible to produce both single-walled and multiwall CNTs.

Further, according to the production apparatus 100 of the present embodiment, the catalyst is formed onto the surface of the aligned CNT aggregate production substrate 10 by a film-forming apparatus provided separately from the production apparatus 100. However, the production apparatus 100 may be configured such that a catalyst film-forming unit is provided upstream of the formation unit 2 so that the aligned CNT aggregate production substrate 10 passes through the catalyst film-forming apparatus before the aligned CNT aggregate production substrate 10 passes through the formation unit 2.

Further, according to the production apparatus 100 of the present embodiment, the formation unit 2, the growth unit 3, and the cooling unit 4 are arranged in this order and have their respective furnace spaces spatially connected via the connecting sections 7, 8, and 9. However, a plurality of units that process steps other than the formation step, the growth step, and the cooling step may be further provided somewhere and have their respective furnace spaces spatially connected via the connecting sections.

Further, according to the production apparatus 100 of the present embodiment, a linear arrangement of the formation unit 2, the growth unit 3, and the cooling unit 4 have been described. However, the present invention is not limited to this. For example, the formation unit 2, the growth unit 3, and the cooling unit 4 may be arranged circularly in this order.

The present invention is not limited to the description of the embodiments above, but may be altered by a skilled person within the scope of the claims. An embodiment based on a proper combination of technical means disclosed in different embodiments is encompassed in the technical scope of the present invention.

[Additional descriptions]

As described above, the apparatus of the present invention is preferably configured such that the apparatus for producing an aligned carbon nanotube aggregate further includes: a cooling unit that includes a cooling furnace for cooling the substrate on which the aligned carbon nanotube aggregate is synthesized; and a connecting section that spatially connects respective furnace spaces of the growth furnace and the cooling furnace, the transfer unit transferring the substrate from the growth unit to the cooling unit, and the heating means heating an internal space of the connecting section.

The apparatus of the present invention is preferably configured such that the apparatus further includes: gas mixing prevention means for preventing a gas outside the growth unit from flowing into the growth unit through the outlet of the growth unit, the gas mixing prevention means including: seal gas injection means for injecting a seal gas along an aperture plane of the outlet of the growth unit through which outlet the substrate exits from the growth unit; and exhaust means for exhausting the seal gas to an outside of the apparatus by sucking the seal gas so as to prevent the seal gas from entering the growth furnace through the outlet of the growth unit.

The apparatus of the present invention is preferably configured such that the heating means is configured to heat the seal gas.

The method of the present invention is preferably configured such that: the growth step is carried out by use of the production apparatus further including gas mixing prevention means for preventing a gas outside the growth unit from flowing into the growth unit through the outlet of the growth unit; and in the growth step, by use of the gas mixing prevention means, while a seal gas is injected along an aperture plane of the outlet of the growth unit through which outlet the substrate exits from the growth unit, the seal gas is exhausted to an outside of the production apparatus by sucking the seal gas so as to prevent the seal gas from entering the growth furnace through the outlet of the growth unit.

The method of the present invention is preferably configured such that: by use of the production apparatus in which the heating means is configured to heat the seal gas, the growth step is carried out while the seal gas is heated by the heating means.

The method of the present invention is preferably configured such that the method further includes a cooling step of, after the growth step, cooling the aligned carbon nanotube aggregate, the catalyst, and the base substrate by use of the production apparatus further including a cooling unit that includes a cooling furnace for cooling the substrate on which the aligned carbon nanotube aggregate is synthesized.

[Examples]

The present invention is specifically described below with reference to Examples. However, the present invention is not limited to these examples. Evaluation was carried out in the present invention in accordance with the following method.

(Measurement of Specific Surface Area)

The term "specific surface area" means a value obtained from an adsorption and desorption isotherm of liquid nitrogen at 77K using the Brunauer-Emmett-Teller equation. The specific surface area was measured using a BET specific surface area measuring device (HM model-1210; manufactured by MOUNTECH Co., Ltd.).

(Bottom-G/D Ratio)

The term "G/D ratio" means an index that is commonly used to evaluate the quality of CNTs. A raman spectrum of CNTs as measured by a raman spectroscopic instrument is observed in vibration modes called "G band" (near 1,600 $cm^{-1}$) and "D band" (near 1,350 $cm^{-1}$). The G band is a vibration mode derived from hexagonal lattice structures of graphite appearing as cylindrical surfaces of CNTs, and the D band is a vibration mode derived from crystal defects. Therefore, with a higher peak intensity ratio of the G band to the D band (G/D ratio), the CNTs can be evaluated to be higher in quality and lower in defect rate.

In the present example, the G/D ratio was calculated by peeling off a part of an aligned CNT aggregate located near the center of a base substrate and measuring a raman spectrum through irradiation with a laser of that surface of the aligned CNT aggregate which had been peeled off from the base substrate, using a microscopic laser raman system (Nicolet Almega XR; manufactured by Thermo Fisher Scientific K.K.).

(Top-G/D ratio)

A top-G/D ratio was measured as in the case of the bottom-G/D ratio, except that the CNTs on the substrate which CNTs had not been peeled off were directly irradiated with a laser.

[Example 1]

Example 1 used a production apparatus illustrated in Fig. 1.

The conditions for production of an aligned CNT aggregate production substrate 10 are described below. The base substrate used was a 90 mm $\times$ 90 mm Fe-Ni-Cr alloy YEF 426 (Ni 42%, Cr 6%; manufactured by Hitachi Metals, Ltd.) with a thickness of 0.3 mm. The surface roughness was measured using a laser microscope, and it was found that the arithmetic average roughness was Ra $\approx$ 2.1 $\mu$m. Alumina films with a thickness of 20 nm were formed on both front and back surfaces of the base substrate with use of a sputtering apparatus. Then, an iron film (catalyst metal layer) with a thickness of 1.0 nm was formed only on the front surface with use of the sputtering apparatus.

The aligned CNT aggregate production substrate 10 thus prepared was placed on the mesh belt of the production apparatus, and subjected to the formation step, the growth step, and the cooling step in this order, whereby aligned CNT aggregates were produced.

The conditions for the inlet purge section 1, the formation unit 2, the gas mixing prevention means 11, 12, and 13, the growth unit 3, the cooling unit 4, and the outlet purge section 5 of the production apparatus were set as follows:

Inlet purge section 1

· Purge gas: nitrogen 60,000 sccm

Formation unit 2

· Furnace temperature: 830°C
· Reducing gas: nitrogen 11,200 sccm, hydrogen 16,800 sccm
· Processing time: 28 minutes

Gas mixing prevention means 11

· Exhaust quantity of the exhaust section 11a: 20 sLm

· Seal gas injection section 11b: nitrogen 20 sLm

Gas mixing prevention means 12

· Exhaust quantity of the exhaust section 12a: 25 sLm
· Seal gas injection section 12b: nitrogen 25 sLm

Gas mixing prevention means 13

· Exhaust quantity of the exhaust section 13a: 20 sLm

· Seal gas injection section 13b: nitrogen 20 sLm

Growth unit 3

- Furnace temperature: 830°C
- Raw material gas: nitrogen 16,040 sccm, ethylene 1,800 sccm, water-vapor-containing nitrogen 160 sccm (moisture content 16,000 ppmv)
- Processing time: 11 minutes

Heating section 13c

· Heating temperature: 600°C

Cooling unit 4

· Cooling water temperature: 30°C
· Inert gas: nitrogen 10,000 sccm
· Cooling time: 30 minutes

Outlet purge section 5

· Purge gas: nitrogen 50,000 sccm

(i) The furnaces and the injection sections of the formation unit 2 and the growth unit 3, (ii) the exhaust sections 11a, 12a, and 13a of the gas mixing prevention means, (iii) the mesh belt, and (iv) the connecting sections 7, 8, and 9 are each made of SUS 310 whose surface is plated with molten aluminum.

Table 1 shows results of measurement of temperatures at the heating section 13c and the connecting section 9, the top-G/D ratio, the bottom-G/D ratio, etc.

[Table 1]

| | Temp. at heating section 13c | Temp. at connecting section 9 (seal gas temp.) | Top-G/D ratio | Bottom-G/D ratio | Specific surface area ($m^2$/g) | Yield (mg/$cm^2$) |
|---|---|---|---|---|---|---|
| Ex. 1 | 600°C | 480°C | 7.5 | 8.6 | 1050 | 2.1 |
| Ex.2 | 400°C | 330°C | 5.1 | 8.2 | 940 | 2.1 |
| Ex.3 | 800°C | 620°C | 6.8 | 7.2 | 1000 | 1.9 |
| Com. Ex.1 | Not heated | 220°C | 3.0 | 8.9 | 910 | 2.0 |
| (Abbreviation: Temp. stands for Temperature.<br>Ex. stands for Example.<br>Com.Ex. stands for Comparative Example.) | | | | | | |

[Examples 2 and 3]

Aligned CNT aggregates were prepared in the same manner as in Example 1, except that the temperature of the heating section 13c was temperatures shown in Table 1, respectively. The CNT aggregate was measured in the top-G/D ratio, the bottom-G/D ratio, etc. Table 1 shows the results of the measurement.

[Comparative Example 1]

Aligned CNT aggregates were prepared in the same manner as in Example 1, except that no heating was carried out by the heating section 13c. The CNT aggregate was measured in the top-G/D ratio, the bottom-G/D ratio, etc. Table 1 shows the results of the measurement.

[Results]

As shown in Table 1, it was confirmed that an aligned CNT aggregate in which a difference between the top-G/D ratio and the bottom-G/D ratio is small can be produced by heating the growth unit 3 by the heating section 13c via the seal gas.

The embodiments and concrete examples of implementation discussed in the foregoing detailed explanation serve solely to illustrate the technical details of the present invention, which should not be narrowly interpreted within the limits of such embodiments and concrete examples, but rather may be applied in many variations within the spirit of the present invention, provided such variations do not exceed the scope of the patent claims set forth below.

Industrial Applicability

An aligned carbon nanotube aggregate obtained by a production method of the present invention is suitably usable in fields of an electronic device material, an optical element material, an electrically conducting material, etc.

Reference Signs List

3: Growth unit
3a: Growth furnace
4: Cooling unit
4a: Cooling furnace
9: Connecting section
10: Aligned CNT aggregate production substrate (substrate for producing aligned carbon nanotube aggregate)
13c: Heating section (heating means)
100: Production apparatus

**Claims**

**1.** An apparatus for producing an aligned carbon nanotube aggregate by synthesizing the aligned carbon nanotube aggregate on a substrate for producing the aligned carbon nanotube aggregate, the substrate being constituted by a base substrate which supports a catalyst on a surface thereof, the apparatus comprising:

a growth unit that includes a growth furnace for synthesizing the aligned carbon nanotube aggregate by causing an environment surrounding the catalyst to be an environment of a raw material gas and by heating at least either the catalyst or the raw material gas;
a transfer unit that transfers the substrate from an inside to an outside of the growth furnace; and
heating means for heating, from the outside of the growth furnace, an outlet of the growth furnace through which outlet the substrate exits from the growth furnace.

**2.** The apparatus as set forth in claim 1, further comprising:

a cooling unit that includes a cooling furnace for cooling the substrate on which the aligned carbon nanotube aggregate is synthesized; and

a connecting section that spatially connects respective furnace spaces of the growth furnace and the cooling furnace,
the transfer unit transferring the substrate from the growth unit to the cooling unit, and
the heating means heating an internal space of the connecting section.

**3.** The apparatus as set forth in claim 1 or 2, further comprising:

gas mixing prevention means for preventing a gas outside the growth unit from flowing into the growth unit through the outlet of the growth unit,
the gas mixing prevention means including:

seal gas injection means for injecting a seal gas along an aperture plane of the outlet of the growth unit through which outlet the substrate exits from the growth unit; and
exhaust means for exhausting the seal gas to an outside of the apparatus by sucking the seal gas so as to prevent the seal gas from entering the growth furnace through the outlet of the growth unit.

**4.** The apparatus as set forth in claim 3, wherein the heating means is configured to heat the seal gas.

**5.** A method for producing an aligned carbon nanotube aggregate by synthesizing the aligned carbon nanotube aggregate on a substrate for producing the aligned carbon nanotube aggregate, the substrate being constituted by a base substrate which supports a catalyst on a surface thereof, the method comprising:

a growth step of synthesizing the aligned carbon nanotube aggregate by use of a production apparatus,
the production apparatus including:

a growth unit that includes a growth furnace for synthesizing the aligned carbon nanotube aggregate by causing an environment surrounding the catalyst to be an environment of a raw material gas and by heating at least either the catalyst or the raw material gas;
a transfer unit that transfers the substrate from an inside to an outside of the growth furnace; and
heating means for heating, from the outside of the growth furnace, an outlet of the growth furnace through which outlet the substrate exits from the growth furnace, and

the growth step being carried out in the growth unit while the outlet is heated from the outside of the growth furnace.

**6.** The method as set forth in claim 5, wherein:

the growth step is carried out by use of the production apparatus further including gas mixing prevention means for preventing a gas outside the growth unit from flowing into the growth unit through the outlet of the growth unit; and
in the growth step, by use of the gas mixing prevention means, while a seal gas is injected along an aperture plane of the outlet of the growth unit through which outlet the substrate exits from the growth unit, the seal gas is exhausted to an outside of the production apparatus by sucking the seal gas so as to prevent the seal gas from entering the growth furnace through the outlet of the growth unit.

**7.** The method as set forth in claim 6, wherein:

by use of the production apparatus in which the heating means is configured to heat the seal gas,
the growth step is carried out while the seal gas is heated by the heating means.

**8.** The method as set forth in claim 5, further comprising a cooling step of, after the growth step, cooling the aligned carbon nanotube aggregate, the catalyst, and the base substrate by use of the production apparatus further including a cooling unit that includes a cooling furnace for cooling the substrate on which the aligned carbon nanotube aggregate is synthesized.

F I G. 1

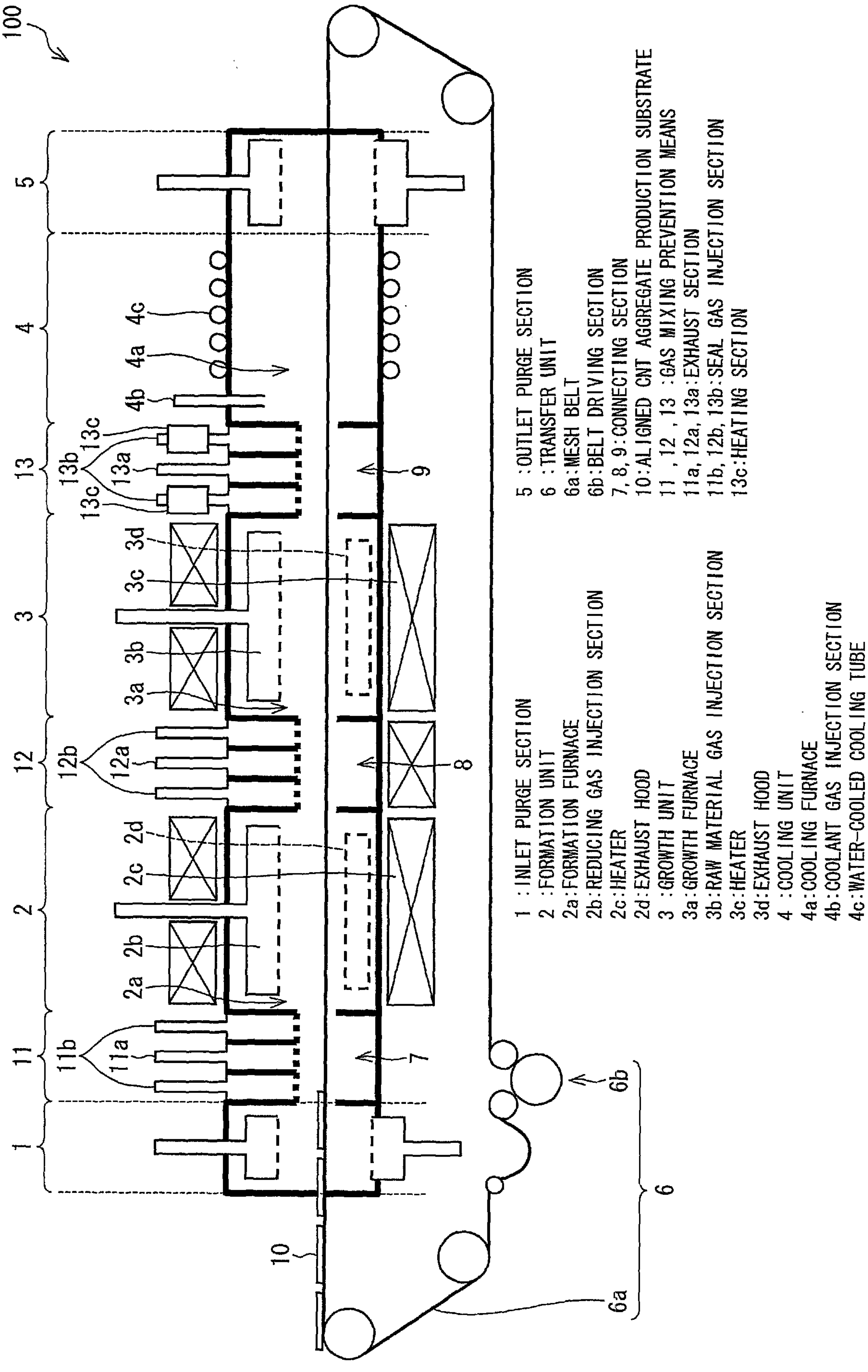
100
1 :INLET PURGE SECTION
2 :FORMATION UNIT
2a:FORMATION FURNACE
2b:REDUCING GAS INJECTION SECTION
2c:HEATER
2d:EXHAUST HOOD
3 :GROWTH UNIT
3a:GROWTH FURNACE
3b:RAW MATERIAL GAS INJECTION SECTION
3c:HEATER
3d:EXHAUST HOOD
4 :COOLING UNIT
4a:COOLING FURNACE
4b:COOLANT GAS INJECTION SECTION
4c:WATER-COOLED COOLING TUBE
5 :OUTLET PURGE SECTION
6 :TRANSFER UNIT
6a:MESH BELT
6b:BELT DRIVING SECTION
7, 8, 9:CONNECTING SECTION
10:ALIGNED CNT AGGREGATE PRODUCTION SUBSTRATE
11 , 12 , 13 :GAS MIXING PREVENTION MEANS
11a, 12a, 13a:EXHAUST SECTION
11b, 12b, 13b:SEAL GAS INJECTION SECTION
13c:HEATING SECTION

**INTERNATIONAL SEARCH REPORT**

International application No.
PCT/JP2012/064005

A. CLASSIFICATION OF SUBJECT MATTER
*C01B31/02*(2006.01)i, *B82Y30/00*(2011.01)i, *B82Y40/00*(2011.01)i

According to International Patent Classification (IPC) or to both national classification and IPC

B. FIELDS SEARCHED

Minimum documentation searched (classification system followed by classification symbols)
C01B31/02, B82Y30/00, B82Y40/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
WPI, CiNii, JSTPlus/JST7580(JDreamII)

C. DOCUMENTS CONSIDERED TO BE RELEVANT

| Category* | Citation of document, with indication, where appropriate, of the relevant passages | Relevant to claim No. |
|---|---|---|
| X | WO 2010/092787 A1 (Nippon Zeon Co., Ltd.), 19 August 2010 (19.08.2010), claims; paragraph [0085]; fig. 1, 2 & EP 2397441 A1 & CN 102307808 A & KR 10-2011-0116028 A | 1-8 |
| X | WO 2009/128349 A1 (Nippon Zeon Co., Ltd.), 22 October 2009 (22.10.2009), claims; paragraph [0072]; fig. 1 to 3 & JP 2010-248073 A & US 2010/0196600 A1 & EP 2263974 A1 & KR 10-2010-0091943 A & KR 10-2011-0063590 A | 1-8 |
| X | WO 2011/001969 A1 (Nippon Zeon Co., Ltd.), 06 January 2011 (06.01.2011), claims; paragraph [0067]; fig. 1, 2 (Family: none) | 1-8 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 June, 2012 (18.06.12) | 26 June, 2012 (26.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2012/064005

C (Continuation). DOCUMENTS CONSIDERED TO BE RELEVANT

| Category* | Citation of document, with indication, where appropriate, of the relevant passages | Relevant to claim No. |
|---|---|---|
| A | US 2010/0279009 A1 (David N. JACQUES), 04 November 2010 (04.11.2010), fig. 1 & US 7160531 B1 & US 2009/0053115 A1 | 1-8 |
| A | WO 2008/153609 A1 (SELDON TECHNOLOGIES INC.), 18 December 2008 (18.12.2008), fig. 1 (Family: none) | 1-8 |
| A | JP 2003-238125 A (Toray Industries, Inc.), 27 August 2003 (27.08.2003), claims (Family: none) | 1-8 |
| A | JP 2003-252613 A (Toray Industries, Inc.), 10 September 2003 (10.09.2003), claims (Family: none) | 1-8 |
| A | JP 2008-531456 A (CNT Co., Ltd.), 14 August 2008 (14.08.2008), claims & US 2008/0159944 A1 & EP 1855988 A1 & WO 2006/107144 A1 & KR 10-2006-0097939 A & CN 101137574 A | 1-8 |
| A | JP 2009-298639 A (Hitachi Zosen Corp.), 24 December 2009 (24.12.2009), claims (Family: none) | 1-8 |
| A | JP 2006-016232 A (Hitachi Zosen Corp.), 19 January 2006 (19.01.2006), claims (Family: none) | 1-8 |

Form PCT/ISA/210 (continuation of second sheet) (July 2009)

**INTERNATIONAL SEARCH REPORT**

International application No.
PCT/JP2012/064005

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

Since documents 1-3 set forth an apparatus for producing an oriented carbon nanotube aggregate, which satisfies the definition of claim 1, the invention of claim 1 is not considered novel over the invention set forth in documents 1-3 and thus does not have a special technical feature.

Consequently, the claims of this international application contain two (groups of) inventions, namely a group of the inventions of claims 1-4 and a group of the inventions of claims 5-8.

In this connection, the invention of claim 1, which does not have a special technical feature, is considered to fall under invention group 1.

(Continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.
PCT/JP2012/064005

Continuation of Box No.III of continuation of first sheet(2)

Document 1: WO 2010/092787 A1 (Nippon Zeon Co., Ltd.), 19 August 2010 (19.08.2010)
Document 2: WO 2009/128349 A1 (Nippon Zeon Co., Ltd.), 22 October 2009 (22.10.2009)
Document 3: WO 2011/001969 A1 (Nippon Zeon Co., Ltd.), 6 January 2011 (06.01.2011)

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2009128349 A
- WO 2011001969 A